(19) Europäisches Patentamt / European Patent Office / Office européen des brevets

(11) **EP 2 385 625 B1**

(12) **FASCICULE DE BREVET EUROPEEN**

(45) Date de publication et mention
de la délivrance du brevet:
**13.03.2019 Bulletin 2019/11**

(51) Int Cl.:
*H03H 9/70* *(2006.01)*          *H03H 9/74* *(2006.01)*
*H03H 9/02* *(2006.01)*          *H03H 9/58* *(2006.01)*

(21) Numéro de dépôt: **11164581.8**

(22) Date de dépôt: **03.05.2011**

(54) **Combineur comprenant des transducteurs acoustiques**

Kombinierer mit akustischem Wandler

Combiner having acoustic transducers

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **04.05.2010 FR 1053444**

(43) Date de publication de la demande:
**09.11.2011 Bulletin 2011/45**

(73) Titulaire: **Commissariat à l'Énergie Atomique
et aux Énergies Alternatives
75015 Paris (FR)**

(72) Inventeurs:
• **Domingue, Frédéric
Québec G8Y 0C2 (CA)**
• **Reinhardt, Alexandre
38400, Saint Martin d'Hères (FR)**

(74) Mandataire: **Esselin, Sophie et al
Marks & Clerk France
Conseils en Propriété Industrielle
Immeuble Visium
22 avenue Aristide Briand
94117 Arcueil Cedex (FR)**

(56) Documents cités:
**DE-A1-102005 027 457      FR-A1- 2 926 421
GB-A- 1 473 661            JP-A- 60 160 719
US-A1- 2010 039 000**

• **NAKAMURA K ET AL: "THIN FILM RESONATORS
AND FILTERS", INTERNATIONAL SYMPOSIUM
ON ACOUSTIC WAVE DEVICES FOR
FUTUREMOBILE COMMUNICATION SYSTEMS,
XX, XX, 5 mars 2001 (2001-03-05), pages 93-99,
XP008048920,**

## Description

DOMAINE DE L'INVENTION

Le domaine de l'invention est celui des dispositifs électromécaniques exploitant la propagation de signaux électriques en vue de réaliser une fonction de combineur de puissance notamment RF tout en conservant une isolation élevée entre les ports d'accès.

ART ANTERIEUR

De tels dispositifs présentent des fréquences de fonctionnement de l'ordre de quelques centaines de KHz à quelques GHz, et sont utilisés dans des systèmes de transmission sans fil, par exemple RF et microondes afin de combiner la puissance de deux signaux. Par exemple, les architectures d'amplificateur évoluées nécessitent ce type de dispositif afin de combiner les signaux amplifiés provenant de multiples branches, il peut notamment s'agir d'amplificateurs linéaires à base de composants non-linéaires (LINC).

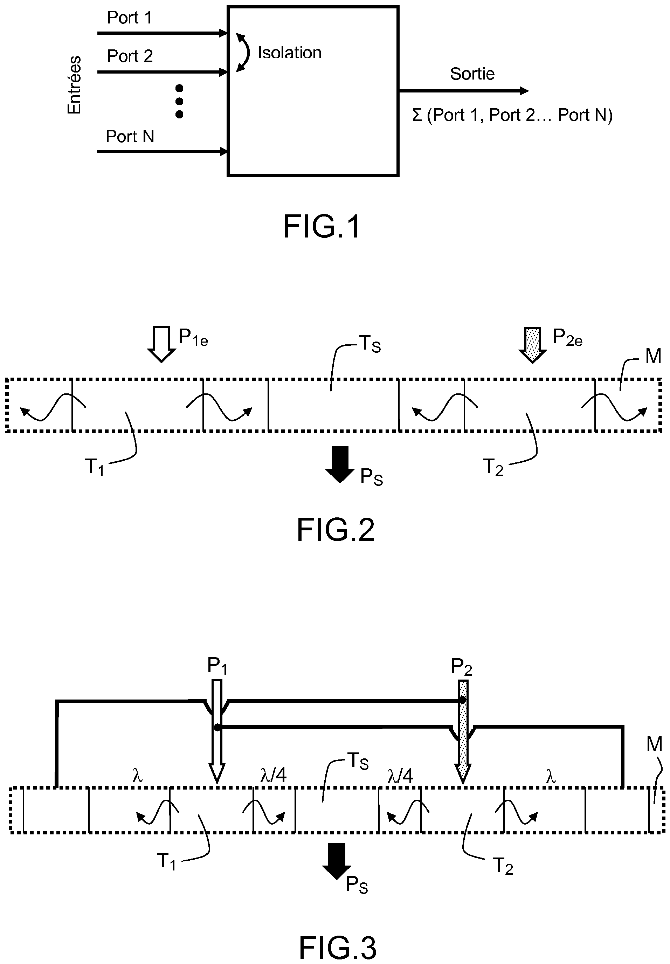

De manière générale, un combineur est un dispositif permettant d'effectuer la combinaison de deux signaux distincts ou plus en un seul signal. Dans le contexte des systèmes sans fil, ce dispositif permet de combiner un ensemble de signaux comme schématisé en figure 1, dans le cas de signaux RF. Selon l'architecture du combineur, il est possible d'obtenir une isolation entre les ports d'entrées. Cette isolation limite l'influence et l'effet de chaque branche sur les autres ports. Les combineurs conventionnels sont faits à partir d'éléments passifs discrets ou de lignes de transmission.

Dans un contexte de communication sans fil mobile, telle la téléphonie portable, les dimensions des circuits doivent être miniaturisées. Toutefois, les solutions traditionnelles occupent un espace encombrant et sont difficilement miniaturisables. Par exemple, la solution avec des composantes discrètes nécessite des composants de fortes valeurs difficiles à intégrer en raison de leurs fortes pertes résultantes. En contrepartie, la solution en ligne de transmission, nécessite de longues lignes en fonction de la longueur électrique. Dans les gammes de fréquences inférieures à quelques GHz, ces longueurs physiques requises sont supérieures au centimètre et peu envisageables en circuit intégré.

Il existe donc un besoin important de trouver des solutions intégrables, c'est-à-dire miniaturisables, afin de permettre la réalisation de nombreuses architectures nécessitant des combinaisons de puissance en particulier RF pour les applications de type téléphonies mobiles et systèmes sans fil portables.

Il est connu du document JP 60160719, un combineur comportant un premier transducteur d'entrée, un second transducteur d'entrée et un transducteur de sortie,

Il est connu du document FR 2 926 421 une structure notamment avec 2 résonateurs d'entrée, les champs acoustiques se sommant au niveau du résonateur de sortie.

Il est également connu du document GB 1 473 661 un dispositif à ondes acoustiques de surface comprenant trois transducteurs : ceux externes étant connectés à des ports d'entrée et un central connecté à un port de sortie, les transducteurs étant disposés de façon à faire soit une combinaison soit une soustraction des signaux mais ne permettant pas d'assurer une fonction d'isolation entre les transducteurs.

OBJET DE L'INVENTION :

C'est pourquoi, dans ce contexte, le Demandeur propose un nouveau type de combineur utilisant des composants acoustiques présentant notamment l'avantage d'être de petite taille, la longueur acoustique étant réduite comparativement à la longueur électrique permettant par la même, une miniaturisation importante et présentant des moyens pour d'une part générer des interférences constructives au niveau du port de sortie et d'autre part isoler lesdits premiers et seconds ports d'entrée par interférences d'ondes acoustiques destructives au niveau desdits ports d'entrée.

De manière générale, les composants acoustiques utilisés principalement pour le filtrage exploitent la capacité d'un matériau piézoélectrique à se déformer sous l'application d'un champ électrique. En présence d'un signal électrique alternatif, des ondes acoustiques sont générées dans les matériaux. L'avantage majeur de ces ondes acoustiques provient de leur très faible vitesse de propagation comparativement aux ondes électromagnétiques. Ainsi, la longueur d'onde acoustique est très courte et permet une miniaturisation considérable sachant que la longueur d'onde est définie comme :

$$\lambda = \frac{V}{f},$$

où $\lambda$ est la longueur d'onde, V la vitesse de propagation acoustique de l'onde et $f$ la fréquence. A titre d'exemple, pour une vitesse de propagation de l'ordre de 5000 m/s, la longueur d'onde est de 5 $\mu$m à une fréquence de 1 GHz, ce qui est considérablement plus court que pour des ondes électromagnétiques, pour comparaison pour une ligne CPW (guide d'onde coplanaire, ou coplanar wave guide en anglais) sur Silicium, la longueur d'onde est de 12 cm à 1GHz.

En convertissant le signal électrique sous forme acoustique, il est possible de le traiter, de l'influencer et d'exploiter le signal propagé. Ce principe a été exploité considérablement pour la réalisation de résonateurs acoustiques et filtres RF de type « FBAR » (*Film Bulk Acoustic Wave*), « SMR » (*Solidly Mounted* Resonator) et « SAW » (*Surface Acoustic Wave*). Les deux premiers types de dispositifs exploitent des ondes dites de volume, car elles se propagent dans l'épaisseur d'une couche piézoélectrique. Ainsi, la cavité dans laquelle on fait entrer l'onde en résonance est simplement la couche piézoélectrique, prise en sandwich entre deux électrodes qui permettent d'amener au composant le signal électrique. Des dispositifs tels que les « FBAR » ou les « SMR », diffèrent par la méthode utilisée pour délimiter la cavité résonante : dans le premier cas, une cavité d'air permet une réflexion totale des ondes acoustiques ; dans le second cas, on utilise un empilement de couches qui se comporte comme un miroir acoustique, analogue aux miroirs de Bragg utilisés dans le domaine optique.

Quant à eux, les dispositifs à ondes acoustiques de surface « SAW », sont réalisés sous leur forme la plus simple en disposant des électrodes en forme de peignes interdigités à la surface d'un substrat piézoélectrique. Dans tous les cas, des conditions aux limites génèrent une onde stationnaire constructive en confinant les ondes acoustiques dans une partie de la structure à la fréquence de résonance. Ce principe permet la réalisation de filtres RF compacts avec un excellent facteur de qualité. D'autre part, la propagation de l'onde acoustique dans les matériaux a pu être utilisée pour la réalisation de lignes à retard.

L'exploitation de ces principes acoustiques peut s'étendre à d'autres dispositifs RF en apportant une solution d'intégrabilité et de performances accrues.

Plus précisément, la présente invention a pour objet un combineur de signaux électriques comprenant au moins un premier élément et un second élément connectés respectivement à un premier port d'entrée ($P_1$) et à un second port d'entrée ($P_2$), et un troisième élément connecté à un port de sortie (Ps), les signaux électriques étant propagés entre les ports d'entrée et de sortie, à l'aide des ondes acoustiques de volume où :

- lesdits premier, second et troisième éléments sont des transducteurs à ondes acoustiques de volume propagées à une longueur d'onde acoustique $\lambda$ ;
- ledit combineur comporte un support de propagation dans lequel sont empilés les transducteurs d'entrée et de sortie, le support de propagation comportant au moins une couche de matériau piézoélectrique apte à permettre la propagation d'ondes acoustiques de volume, chaque transducteur comprenant un empilement d'au moins une couche de matériau piézoélectrique et d'au moins deux électrodes respectivement disposées d'une part et d'autre de la couche de matériau piézoélectrique ;

caractérisé en ce que :

- ledit combineur comporte une structure de repliement du chemin du signal qui se propage dans la structure à la fois sous forme électrique et sous forme acoustique, la structure de repliement comportant trois niveaux de résonateurs à ondes de volume, empilés dans l'ordre suivant :

  ○ un premier niveau comprenant un transducteur à ondes acoustiques de volume inférieur;
  ○ un second niveau comprenant, en tant que premier élément, un premier transducteur intermédiaire à ondes acoustiques de volume connecté au premier port d'entrée ($P_1$) et, en tant que second élément, un second transducteur intermédiaire à ondes acoustiques de volume connecté au second port ($P_2$), lesdits transducteurs intermédiaires étant séparés du transducteur inférieur par une première couche intermédiaire;
  ○ un troisième niveau comprenant, en tant que troisième élément, un transducteur supérieur à ondes acoustiques de volume connecté au port de sortie (Ps), séparé des transducteurs intermédiaires par une seconde couche intermédiaire;
  ○ l'épaisseur totale du transducteur supérieur et de la seconde couche intermédiaire présentant une épaisseur totale de $(2k+1)\lambda/4$ avec k entier supérieur ou égal à 0;
  ○ l'épaisseur totale des transducteurs intermédiaires et de la première couche intermédiaire présentant une épaisseur totale de $(2k'+2)\lambda/4$ avec k' entier supérieur ou égal à 0;

de manière à d'une part générer des interférences constructives au niveau du port de sortie et d'autre part isoler lesdits premiers et seconds ports d'entrée par interférence d'ondes acoustiques destructives au niveau desdits ports d'entrée.

L'invention utilise donc le principe de conversion notamment d'une onde RF ou microondes en onde acoustique afin d'exploiter les propriétés de propagation acoustique dans les matériaux acoustiques. Le combineur acoustique de l'invention utilise ainsi un couplage acoustique entre des ondes acoustiques de volume, dans un matériau piezoélectrique.

Selon une variante de l'invention, les transducteurs comportent un matériau piézoélectrique à fort coefficient de couplage piézoélectrique supérieur à 0,5% et de préférence supérieur à 10%.

Selon une variante de l'invention, les transducteurs comprennent une couche piézoélectrique en AIN, les couches intermédiaires étant en $SiO_2$.

Pour des ondes acoustiques de Lamb ou de volume, le matériau piézoélectrique choisi est avantageusement de l'AIN, néanmoins le matériau piézoélectrique peut être aussi du $LiNBO_3$ ou du $LiTaO_3$ ou encore du BST, du STO, du PZT,.... Les couches intermédiaires quant à elles peuvent être en matériaux piézoélectriques ou en $SiO_2$ ou en SiN ou métal.

Selon une variante de l'invention, le combineur est un combineur RF.

LISTE DES FIGURES :

L'invention sera mieux comprise et d'autres avantages apparaîtront à la lecture de la description qui va suivre et grâce aux figures annexées parmi lesquelles :

- la figure 1 illustre le schéma d'un combineur de signaux RF;
- la figure 2 illustre un combineur RF acoustique selon un exemple qui ne fait pas partie de l'invention, mai qui est utile pour la comprendre mieux;
- la figure 3 illustre une variante de combineur RF acoustique selon un exemple qui ne fait pas partie de l'invention, mai qui est utile pour la comprendre mieux
- la figure 4 illustre une variante généralisant la structure de transducteurs illustrée en figure 3 ;
- la figure 5 illustre la réponse en fréquence d'un combineur classique sans isolation des ports d'entrée tel que représenté en figure 2 ;
- la figure 6 illustre la réponse en fréquence du combineur isolé pour une cellule élémentaire, dans un combineur tel que celui représenté en figure 3 ;
- la figure 7 illustre les performances avec une série de sous-ensembles de trois transducteurs, dans un combineur selon un exemple qui ne fait pas partie de l'invention;
- la figure 8 une vue schématique d'un combineur acoustique exploitant des ondes de Lamb selon un exemple qui ne fait pas partie de l'invention ;
- les figures 9a et 9b illustrent des vues en coupe d'un exemple de combineur RF selon un exemple comportant des dispositifs à ondes de Lamb à la surface d'une membrane ;
- les figures 10a à 10k illustrent les différentes étapes d'un procédé de fabrication d'un combineur RF à ondes de Lamb comprenant une membrane suspendue tel que celui représenté en figures 9a et 9b ;
- les figures 11a et 11b illustrent des vues d'un combineur RF comportant des dispositifs à ondes de Lamb confinées par une structure de miroir de Bragg ;
- les figures 12a à 12i illustrent les différentes étapes d'un procédé de fabrication du combineur tel que représenté en figures 11a et 11b ;
- les figures 13a, 13b et 13c représentent respectivement des résonateurs et des ports associés, la propagation du signal du port $P_1$ vers le port de sortie Ps, et la propagation du signal du port $P_1$ vers le port $P_2$., dans un combineur acoustique utilisant des ondes de volume selon l'invention ;
- la figure 14a et 14b représentent une vue en coupe de l'empilement technologique et une vue de dessus d'un combineur RF à ondes de volume selon l'invention ;
- les figures 15a à 15t illustrent les différentes étapes d'un procédé de fabrication du combineur représenté en figures 14a et 14b ;

DESCRIPTION DETAILLEE DE L'INVENTION :

L'invention est décrite ci-après pour un combineur de type RF, étant bien entendu que l'invention peut s'appliquer à d'autres types de fréquences.

Typiquement, le combineur acoustique de l'invention peut être réalisé par couplage acoustique entre des ondes de volume dans un matériau piézoélectrique.

La structure du combineur comprend au moins trois transducteurs (dispositifs permettant la génération d'ondes acoustiques dans un milieu dit acoustique M, à partir d'un signal électrique, ou vice-versa), un premier transducteur $T_1$ connecté à un premier port d'entrée $P_{1e}$, un second transducteur $T_2$ connecté à un second port électrique d'entrée $P_{2e}$ et un troisième transducteur Ts connecté à un port électrique de sortie $P_s$.

Les transducteurs correspondant aux ports $P_{1e}$, $P_{2e}$ ont pour but principal la génération d'ondes portant le signal électrique. Ces ondes interagissent constructivement au niveau du transducteur correspondant au port de sortie, comme représenté sur la figure 2, qui illustre un exemple qui ne fait pas partie de l'invention, mai qui est utile pour la comprendre.

Afin d'optimiser les structures de combineurs précédemment décrites, il peut être particulièrement intéressant d'améliorer l'isolation entre les ports d'entrées si la position des transducteurs connectés à des ports d'entrée est quelconque.

Selon un autre exemple qui ne fait pas partie de l'invention, le combineur RF comporte des transducteurs d'entrée et de sortie à ondes de surface permettant des combiner en sortie des puissances de signaux RF. Ainsi, il est proposé d'introduire une isolation des ports d'entrée entre eux comme illustré en figure 3. Ainsi le combineur RF comporte un premier transducteur $T_1$ connecté à un premier port d'entrée $P_1$ et un second transducteur $T_2$ connecté à un deuxième port d'entrée $P_2$ et un troisième transducteur $T_s$ connecté à un troisième port de sortie $P_s$, le premier transducteur est séparé du troisième transducteur par une distance égale à $\lambda/4$, de même que le second transducteur est séparé du troisième transducteur par une distance égale à $\lambda/4$.

Ainsi, la structure de base mentionée repose sur une isolation des ports produite par une interférence destructive des signaux propagés entre les différents ports d'entrée dans une ligne acoustique. Pour ce faire, on utilise le fait que chaque transducteur émet des ondes dans deux directions opposées à chaque fois. On place alors les transducteurs d'un port (par exemple 1, entre deux transducteurs d'un autre port, par exemple 2, situés de manière à ce qu'au niveau du port $P_1$ les déphasages des ondes émises par les deux transducteurs du port $P_2$ soient de 180°, ce qui génère des interférences destructives. A l'inverse, on place le transducteur de sortie entre des transducteurs des ports $P_1$ et $P_2$ à une position où les déphasages des ondes émises par chacun de ces ports soient égaux, ce qui génère des interférences constructives au niveau de la sortie.

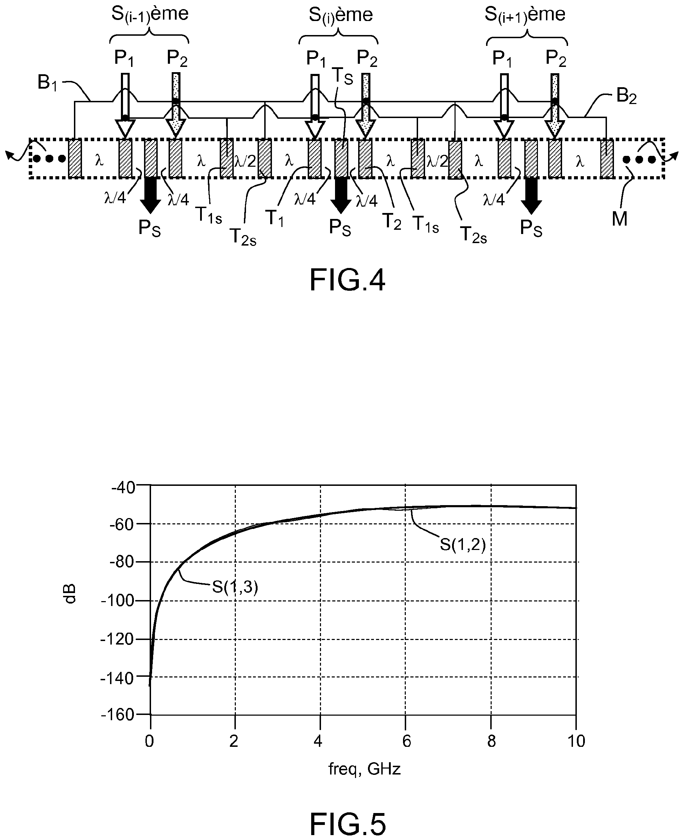

Avantageusement, on peut faire en sorte que les ondes exploitées circulent dans une répétition périodique. Des bus $B_1$ et $B_2$ assurent les interconnexions entre tous les ports $P_1$ et tous les ports $P_2$. Ceci peut être obtenu en répétant physiquement la structure de base, comme représenté en figure 4, et/ou en repliant le trajet des ondes par utilisation de réflecteurs appropriés. De cette manière, les pertes produites par la conversion électrique-acoustique se trouvent réduites. De plus, on évite ainsi les fuites d'énergie par génération d'ondes capables de quitter le réseau de transducteurs. La période de la cellule de base est fixée de manière à respecter la phase du signal et de récupérer un maximum de puissance.

Plus précisément la figure 4 met en évidence, une série de sous-ensembles $S_{i-1}$, $S_i$ et $S_{i+1}$. Chaque sous-ensemble comporte entre chaque ième sous-ensemble comportant respectivement un premier transducteur $T_1$, un transducteur de sortie $T_s$ et un second transducteur $T_2$ et :

- un premier transducteur dit secondaire $T_{1s}$ connecté au premier port et positionné à une distance acoustique égale à $\lambda$ du second transducteur appartenant au ième sous-ensemble,
- un second transducteur dit secondaire $T_{2s}$ connecté au second port et positionné à une distance acoustique égale à $\lambda/2$ dudit premier transducteur secondaire et à une distance acoustique égale à $\lambda$ du premier transducteur du (i+1)ème sous-ensemble.

Notons que le choix du matériau piézoélectrique influence grandement le niveau des pertes d'insertion. Le coefficient de couplage électromécanique affecte directement la transmission possible. Il est donc possible de minimiser le nombre de périodes requises en utilisant les matériaux à fort couplage piézoélectrique.

Exemple d'un combineur RF comportant des transducteurs à ondes de Lamb dans un composant à membrane suspendue.

Selon cet exemple, qui ne fait pas partie de l'invention, le combineur RF exploite la propagation d'ondes de Lamb, qui correspondent à des ondes se propageant dans une plaque, et confinées dans cette plaque étant donné leur réflexion aux interfaces solide/air.

Plus précisément, le combineur comporte une plaque de matériau piézoélectrique dans laquelle sont propagées des ondes de Lamb. Ce matériau peut être de type AlN, l'épaisseur de cette couche étant de 2000 nm. Les électrodes inférieures sont définies dans une couche de Molybdène de 200 nm d'épaisseur, les électrodes supérieures étant définies dans une couche en AlSi également de 200 nm d'épaisseur. L'ensemble des transducteurs est recouvert d'une couche protectrice en SiO$_2$ de 500 nm.

Dans un tel empilement, les ondes de Lamb se propagent à une vitesse de 7800 m/s en présence de la métallisation supérieure et de 8400 m/s en l'absence d'électrode supérieure. Ces vitesses peuvent être calculées par diverses méthodes décrites dans la littérature : par éléments finis ou par des méthodes numériques telles que par exemple la matrice de réflexion (*scattering matrix method* en anglais), comme décrit notamment dans les articles : A.Reinhardt, V.Laude, M.Solal, S.Ballandras et W.Steiche, Investigation of spurious résonances in Thin Film Bulk Acoustic Wave Resonators, Proceedings of the 2004 IEEE Ultrasonics Symposium et S.Ballandras, V.Laude, Simulation of transverse effects in FBAR devices, 2005 IEEE MTT6S Digest.

La structure du combineur comporte ainsi trois séries de peignes d'électrodes, respectivement connectés à un premier port d'entrée, à un second port d'entrée et à un port de sortie. Les électrodes des peignes sont aussi couramment appelés doigts. De plus, chaque peigne comporte des doigts ou électrodes, inférieures et supérieures.

La structure d'un combineur avec isolation des ports d'entrée la plus compacte correspond à une structure à 4 doigts par longueur d'onde (de manière à avoir un quart de longueur d'onde de centre de doigt à centre de doigt), même si tous les doigts ne sont pas présents comme l'illustrent les figures 3 et 4.

La largeur a des peignes est égale à 1/8 de la longueur d'onde de l'onde sous les peignes, soit approximativement 300 nm à une fréquence de 3.5 GHz.

La distance entre les peignes est variable en fonction de la position dans le réseau de peignes afin de définir les séries de trois transducteurs.

Dans un sous-ensemble comportant deux transducteurs dits d'entrée $T_1$ et $T_2$ et un transducteur de sortie Ts, la distance b entre un doigt de premier peigne et un doigt de peigne de sortie est égale à 300 nm, les peignes étant distants d'un quart de longueur d'onde.

Entre un doigt de premier peigne correspondant à un transducteur secondaire $T_{1s}$ et un doigt d'un second peigne correspondant à un transducteur secondaire $T_{2s}$, la distance c est égale à 900 nm, les peignes étant distants d'une demi-longueur d'onde.

Entre un doigt de premier peigne correspondant à un transducteur secondaire $T_{1s}$ et un doigt d'un second peigne correspondant à un transducteur $T_{2s}$, la distance d est égale à 2,1 $\mu$m, les peignes étant distants d'une longueur d'onde

Il est bien sûr possible de faire varier les distances entre peignes, tant que le déphasage reste constant, modulo $2\pi$.

Les performances d'un combineur avec isolation des ports d'entrée ont été comparées à celles d'un combineur RF sans isolation des ports d'entrée.

Pour une structure de combineur RF dans laquelle, les ports d'entrée ne sont pas isolés, la figure 5 représente la réponse calculée pour la configuration présentée sur la figure 2. Les pertes sont élevées dans une telle structure car elle ne présente aucun confinement des ondes acoustiques émises au niveau des ports d'entrée. On note également une absence d'isolation entre les ports $P_1$ et $P_2$. Les courbes S(1,2) et S(1, 3) correspondant respectivement à la transmission du signal du port 1 vers le part 2 et le port 3 sont presque confondues.

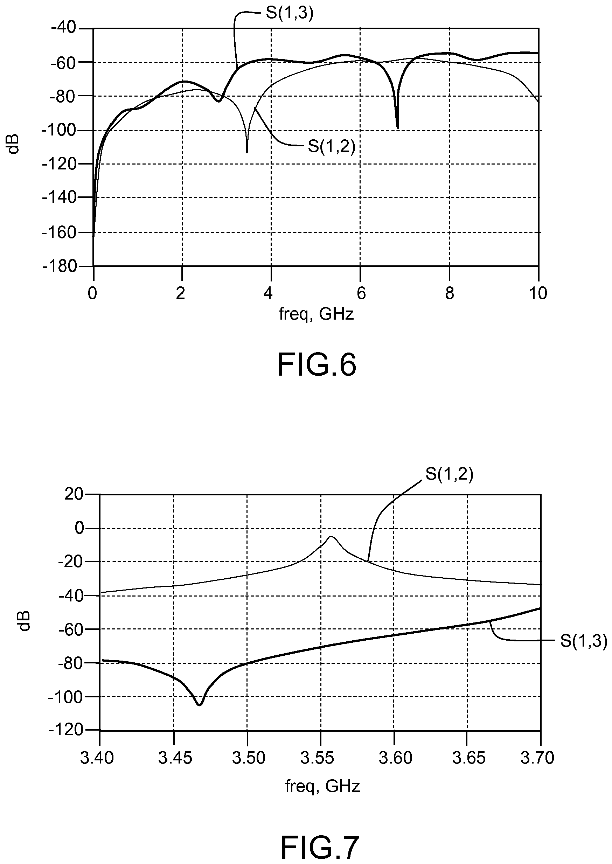

La figure 6 présente le résultat d'une cellule élémentaire de combineur avec ports isolés, selon l'exemple précédemment mentionné. Cette figure montre la pertinence de l'invention détaillée ici en apportant une isolation importante entre les canaux.

Les résultats de la figure 7 montrent l'intérêt de la combinaison périodique telle qu'illustrée en figure 4, de plusieurs cellules élémentaires afin de réduire les pertes d'insertion. En augmentant le nombre de cellules, il est possible de minimiser les pertes d'insertion considérablement.

Nous allons décrire plus en détails ci-après un exemple non-revendiqué de combineur RF comportant des transducteurs à ondes de Lamb avec son réseau d'interconnexions.

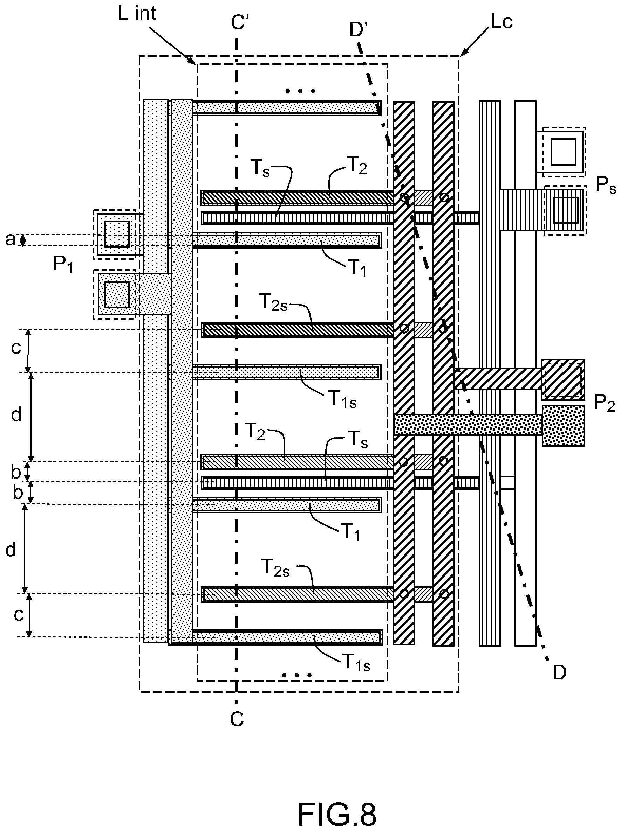

La structure du combineur comporte trois séries de peignes d'électrodes, respectivement connectés à un élément de port d'entrée $P_1$, à un second port d'entrée $P_2$ et à un port de sortie $P_s$ , chaque peigne comportant des électrodes inférieures et des électrodes supérieures comme illustré en figure 8. Deux cadres représentés en pointillés, définissent d'une part les limites Lc de la cavité sous la membrane suspendue permettant la propagation d'ondes de Lamb et les limites des ouvertures du matériau isolant des interconnexions $L_{int}$.

Les trois ports sont représentés par des motifs différents.

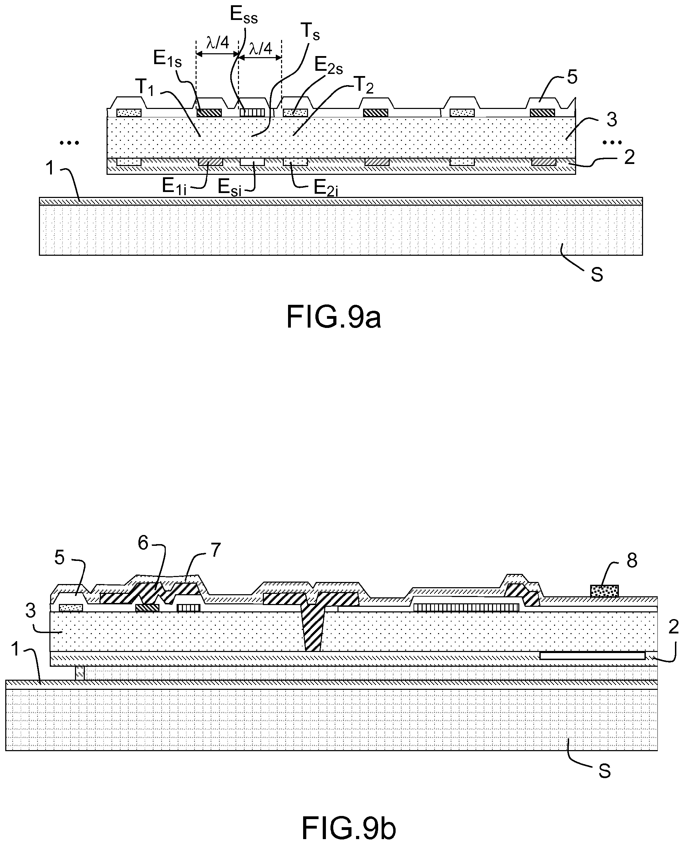

Les figures 9a et 9b représentent deux vues en coupe du composant : l'une selon une coupe C-C' montrant une section de la partie active du combineur, et l'autre étant une vue en coupe selon l'axe D-D' montrant l'organisation des interconnections.

Les dimensions et espacements entre peignes sont calculés comme indiqué dans la section « Exemples numériques ».

Plus précisément, le composant comprend une membrane suspendue au dessus d'un substrat S, comportant une couche d'oxyde 1. La membrane suspendue comprend une couche de matériau piézoélectrique 3, sur laquelle sont réalisées de part et d'autre des électrodes connectées aux ports $P_1$, $P_2$ et $P_s$, des électrodes inférieures $E_{1i}$, $E_{si}$ et $E_{2i}$ et des électrodes supérieures $E_{1s}$, $E_{ss}$ et $E_{2s}$. Les électrodes $E_{1i}$ et $E_{1s}$ définissent le premier résonateur d'entrée connecté au premier port d'entrée, les électrodes $E_{2i}$ et $E_{2s}$ définissent le second résonateur d'entrée connecté au second port d'entrée, les électrodes $E_{si}$ et $E_{ss}$ définissant le résonateur connecté au port de sortie.

Les deux résonateurs d'entrée sont séparés d'une distance acoustique de $\lambda /2$ , chaque résonateur d'entrée étant séparé du résonateur de sortie par une distance acoustique de $\lambda /4$.

Une couche 5 isolante est déposée à la surface de l'ensemble des électrodes supérieures.

Des couches d'interconnexions 6 et 8 permettent de réaliser les prises de contact nécessaires et sont isolées entre elles par une couche isolante 7.

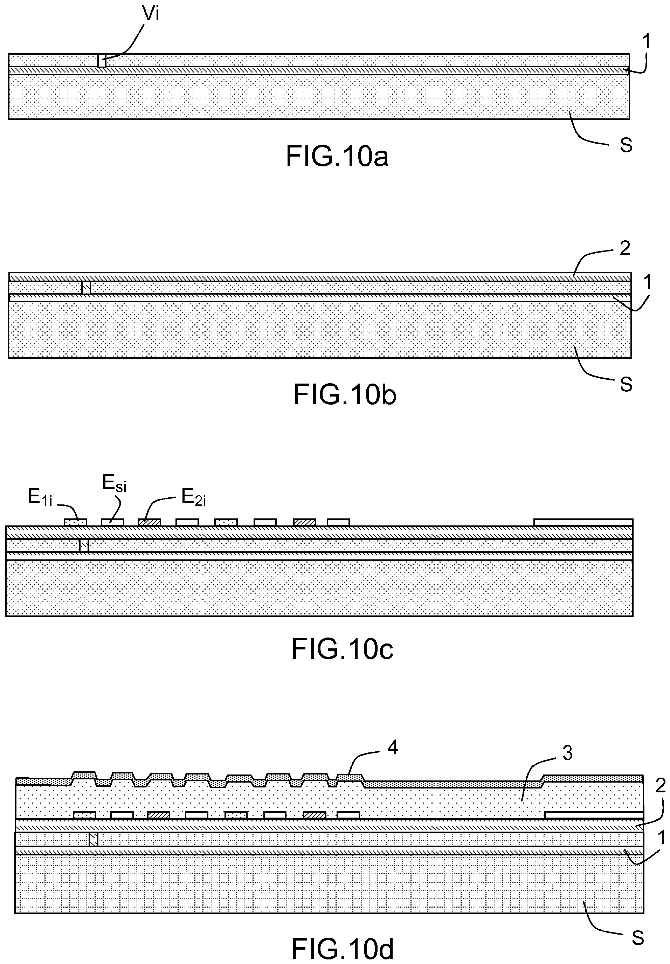

Les figures 10a à 10k illustrent les différentes étapes de fabrication d'un tel combineur RF.

Selon une première étape illustrée en figure 10a, on réalise à partir d'un substrat S, en SOI pour « Silicon On Insulator », des tranchées Vi, le substrat SOI étant un substrat silicium avec une couche de $SiO_2$ intégrée 1 et élaboré selon des techniques connues.

Selon une seconde étape illustrée en figure 10b, on procède à une opération d'oxydation thermique de manière à définir une couche supérieure et des caissons en oxyde de silicium $SiO_2$, conduisant ainsi à la présence de deux couches d'oxydes 1 et 2.

Selon une troisième étape illustrée en figure 10c, on procède au dépôt et à la structuration des électrodes inférieures en molybdène, $E_{1i}$, $E_{2i}$ et $E_{si}$ correspondant à un premier niveau de connexion.

Selon une quatrième étape illustrée en figure 10d, on procède au dépôt de la couche de matériau piézoélectrique 3 en AlN et on réalise le dépôt d'une couche supérieure 4 en molybdène.

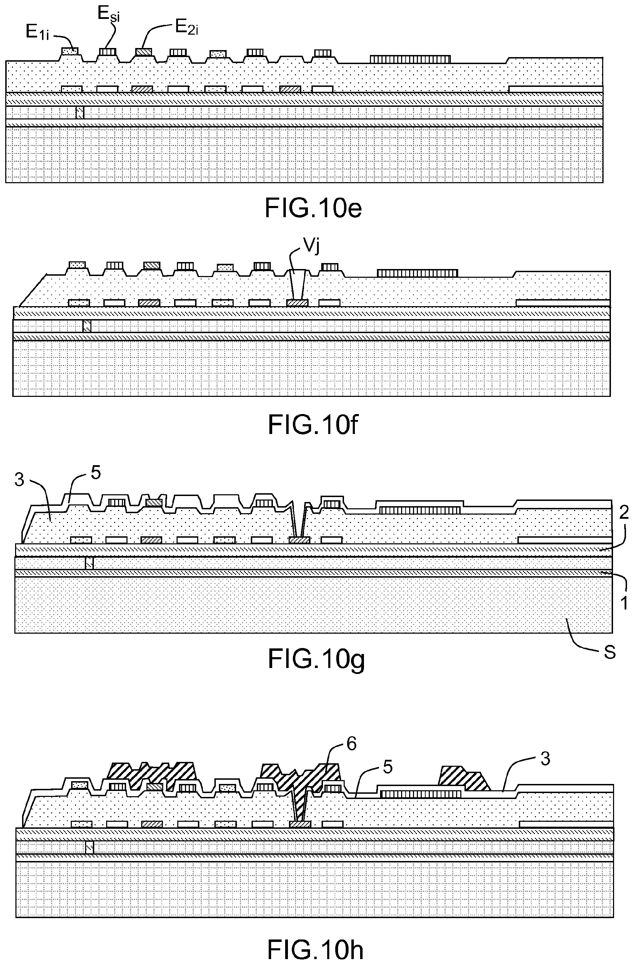

Selon une cinquième étape illustrée en figure 10e, on réalise par structuration de la couche 4, les électrodes supérieures $E_{1s}$, $E_{2s}$, $E_{ss}$ par gravure sèche fluorée et ainsi le second niveau de connexion.

Selon une sixième étape, illustrée en figure 10f, on procède à la gravure du matériau AlN par gravure humide $H_3PO_4$, afin de réaliser des via Vj.

Selon une septième étape illustrée en figure 10g, on procède au dépôt d'une couche 5 en SiN destinée à protéger la couche de matériau piézoélectrique, suivi de l'ouverture de contacts par gravure sèche fluorée.

Selon une huitième étape illustrée en figure 10h, on procède au dépôt d'une couche d'alumium 6, qui est gravée par gravure humide $H_3PO_4$, permettant de définir le troisième niveau de connexion.

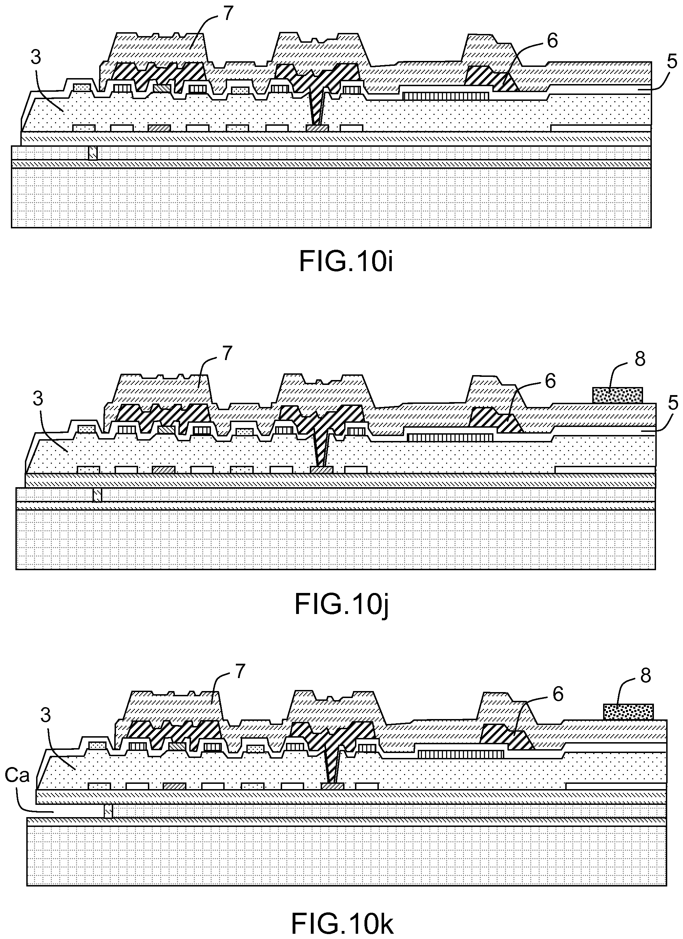

Selon une neuvième étape illustrée en figure 10i, on procède au dépôt d'une couche 7 de $SiO_2$. et à une étape de gravure humide par HF par exemple afin de définir des interconnexions.

Selon une dixième étape illustrée en figure 10j, on procède au dépôt d'une couche d'aluminium 8, sa structuration permettant de définir le quatrième niveau de connexion.

Selon une onzième étape illustrée en figure 10k, on libère la membrane par gravure du silicium avec un gaz $XeF_2$, permettant de réaliser des dispositifs acoustiques à ondes de Lamb avec une cavité Ca, libérant la membrane suspendue.

Une étape d'ajustement de fréquence du composant par gravure localisée de la couche de SiN protégeant la partie active peut être envisagée. On utilise pour cela, par exemple, un équipement de gravure par faisceau d'amas d'atomes, par exemple de $NF_3$.

<u>Exemple d'un combineur RF comportant des transducteurs à ondes de Lamb dans un composant comportant une structure de miroir de Bragg.</u>

Le combineur acoustique RF est ainsi réalisé en exploitant des ondes guidées dans une couche piézoélectrique et confinées par l'utilisation d'une structure de miroir de Bragg. De telles ondes sont semblables au premier abord aux ondes de Lamb présentées précédemment.

Le dimensionnement d'une telle structure se fait donc de la même manière : calcul de la vitesse des ondes exploitées dans les sections métallisées et non métallisées par des méthodes similaires à celles utilisées pour les ondes de Lamb, puis dimensionnement des motifs de peignes interdigités selon la même méthode.

Pour un tel composant, la représentation de la figure 8, reste identique, hormis la suppression des limites de la cavité formée sous le combineur.

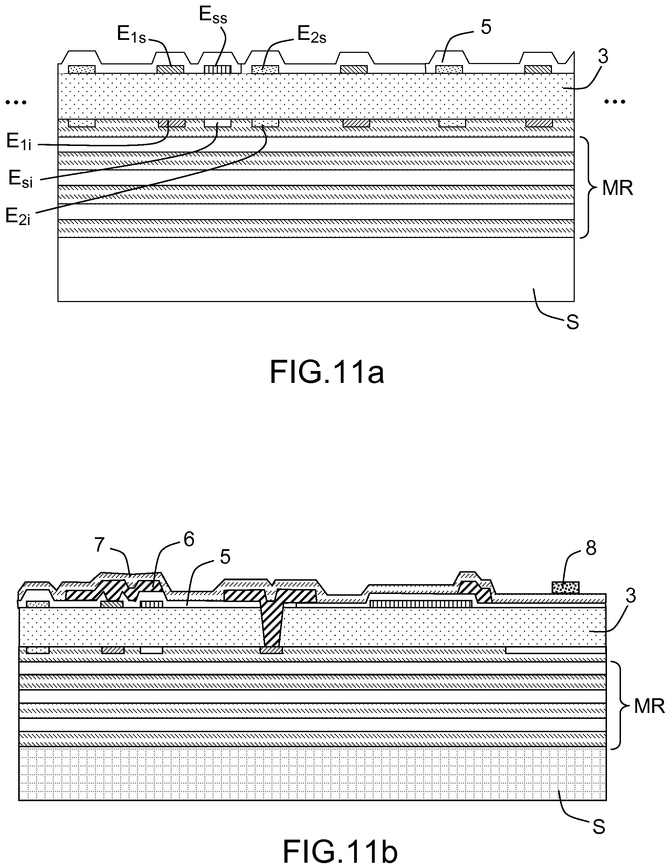

Les figures 11a et 11b présentent des vues en coupe selon l'axe C-C' et selon l'axe D-D'. La structure de la couche piézoélectrique 3 et des électrodes permettant de réaliser l'ensemble des transducteurs, est confinée à la surface d'une structure de miroir de Bragg MR, composé d'un empilement de couches. Les couches 5, 6, 7 et 8 correspondent à celles décrites en liaison avec les figures 9a et 9b.

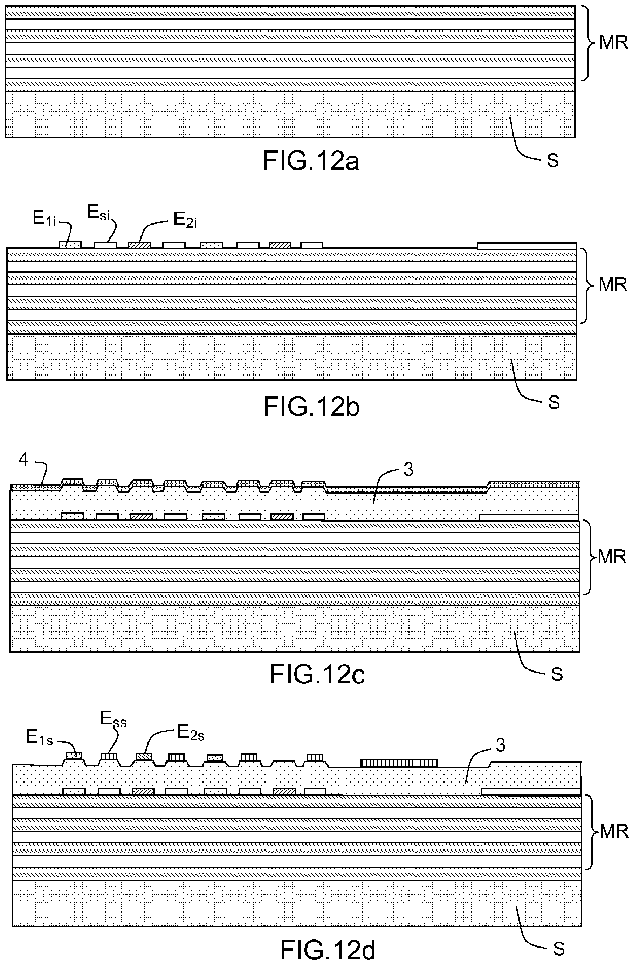

Un exemple de procédé de réalisation est illustré grâce aux figures 12a à 12i.

Selon une première étape du procédé illustré en figure 12a, on réalise un miroir de Bragg, par dépôts successifs de couches de SiN et de SiOC, composant le miroir de Bragg MR, sur un substrat silicium haute résistivité.

Selon une seconde étape illustrée en figure 12b, on procède au dépôt suivi de la structuration des électrodes inférieures en molybdène, $E_{1I}$, $E_{2i}$ et $E_{si}$, définissant ainsi le premier niveau de connexion.

Selon une troisième étape illustrée en figure 12c, on procède au dépôt d'une couche de matériau piézoélectrique 3 en AIN avec dépôt de couche supérieure 4 en Molybdène destinée à la réalisation des électrodes supérieures.

Selon une quatrième étape illustrée en figure 12d, on procède à la structuration de ladite couche pour réaliser les électrodes supérieures $E_{1s}$, $E_{2s}$, $E_{ss}$ par gravure sèche fluorée.

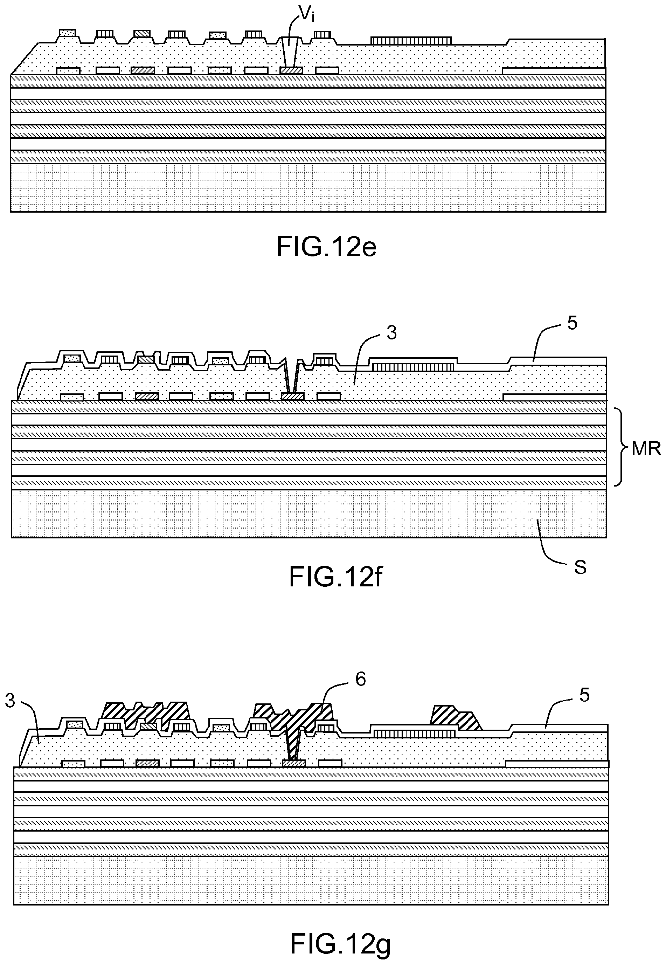

Selon une cinquième étape illustrée en figure 12e, on procède à la gravure de la couche de matériau piézoélectrique en AIN par gravure humide avec du $H_3PO_4$ permettant l'obtention de via Vi.

Selon une sixième étape, illustrée en figure 12f, on procède au dépôt d'une couche 5 de SiN puis à l'ouverture de contacts, par gravure sèche fluorée.

Selon une septième étape illustrée en figure 12g, on procède au dépôt d'une couche d'alumium 6, qui est gravée par gravure humide $H_3PO_4$, permettant de définir le troisième niveau de connexion.

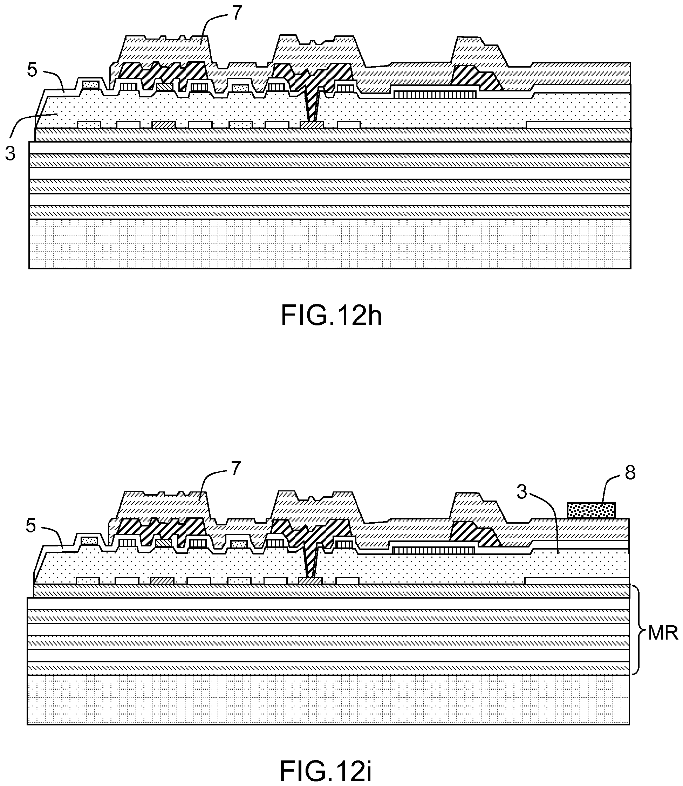

Selon une huitième étape illustrée en figure 12h, on procède au dépôt d'une couche 7 de $SiO_2$, et à une étape de gravure humide par HF par exemple, afin de définir des interconnexions.

Selon une neuvième étape illustrée en figure 12i, on procède au dépôt d'une couche 8 d'aluminium dont la structuration permet de définir le quatrième niveau de connexion.

Une étape d'ajustement de fréquence du composant par gravure localisée de la couche de SiN protégeant la partie active peut être envisagée. On utilise pour cela, par exemple, un équipement de gravure par faisceau d'amas d'atomes, par exemple de $NF_3$.

<u>Exemple de réalisation d'un combineur RF comportant des transducteurs à ondes de volume.</u>

Dans cet exemple, le combineur acoustique RF exploite des ondes acoustiques de volume. Pour ce faire, on utilise des ondes se propageant verticalement dans l'empilement de couches. Au lieu d'exciter les ondes en utilisant des peignes interdigités, on utilise des empilements métal / piézoélectrique / métal, similaires à des résonateurs BAW habituels. Leur épaisseur n'est toutefois plus d'une demi-longueur d'onde comme cela est habituellement le cas pour les résonateurs BAW classiques.

D'autre part, pour ne pas complexifier outre mesure le procédé de réalisation, on ne place pas tous les résonateurs l'un au-dessus de l'autre (alignés dans la direction de propagation), mais on utilise une technique de « repliement » du chemin du signal qui se propage dans la structure à la fois sous forme électrique et sous forme acoustique.

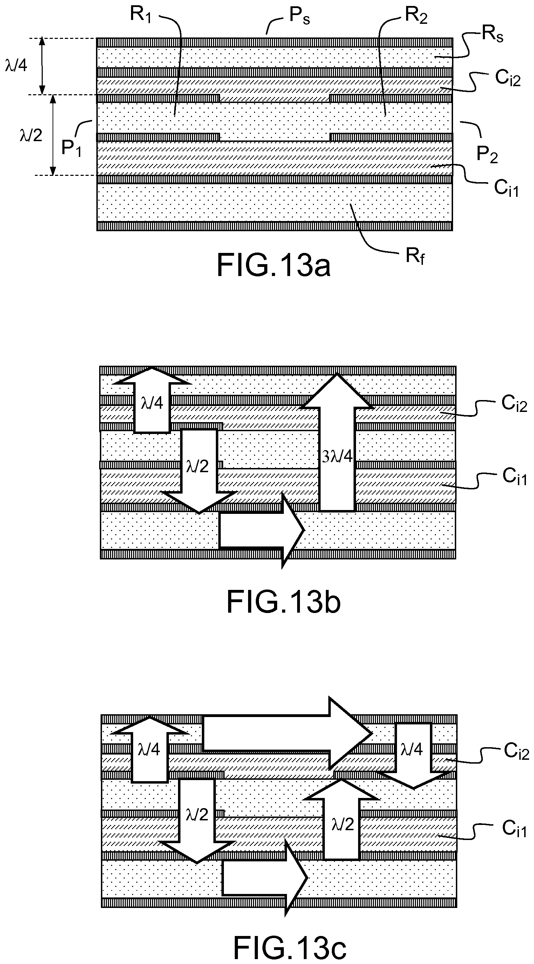

Une représentation schématique est illustrée grâce aux figures 13a, 13b et 13c. On utilise deux sections chacune composée de 3 niveaux de résonateurs empilés, entre lesquels on insère une ou plusieurs couches dites intermédiaires dont le but est de fournir aux ondes acoustiques un déphasage lors de sa propagation à travers la structure.

Plus précisément on définit un résonateur inférieur dit flottant, en raison de ces électrodes mises à un potentiel flottant, deux résonateurs $R_1$ et $R_2$ au niveau intermédiaire et connectés respectivement à un premier port d'entrée $P_1$ et à un second port d'entrée $P_2$ et un résonateur $R_s$ dit de sortie.

Les résonateurs $R_1$ et $R_2$ sont couplés à une première couche intermédiaire $C_{i1}$ et le résonateur de sortie est couplé à une seconde couche intermédiaire $C_{i2}$.

Les flèches illustrent la propagation des ondes acoustiques de volume au sein d'une telle structure et schématisent les trajets en sortie directe depuis un port d'entrée et en sortie depuis un port opposé.

Ainsi, les épaisseurs du résonateur supérieur de sortie et de la première couche intermédiaire sont calculées de manière à fournir un déphasage de $\pi/12$ à leur traversée par l'onde. Les épaisseurs des résonateurs d'entrée et de la seconde couche intermédiaire sont, elles, calculées pour fournir un déphasage de $\pi$ à leur traversée. Les deux électrodes du résonateur supérieur sont reliées au port de sortie du composant, et s'étendent sur les deux sections en même temps.

Les ports $P_1$ et $P_2$ sont chacun reliés aux électrodes des résonateurs intermédiaires. Quant au résonateur inférieur, il s'étend lui aussi sur les deux sections en même temps, mais ses électrodes sont laissées flottantes.

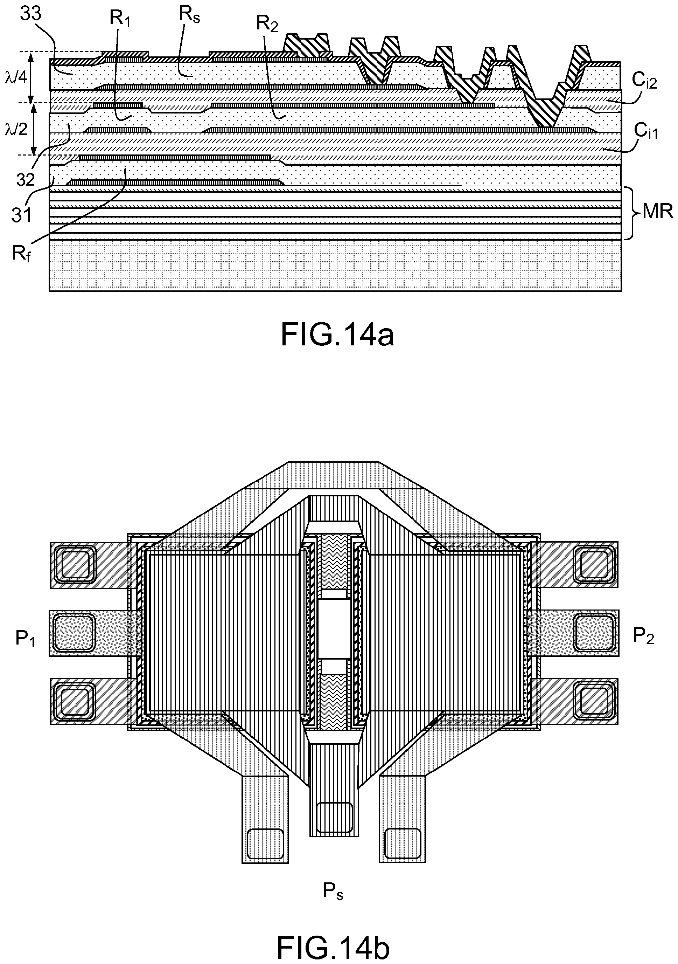

Une vue en coupe de l'empilement technologique et une vue de dessus utilisant les mêmes conventions de motifs que précédemment, sont présentées sur la figure 14a et 14b.

Nous allons décrire ci-après un exemple de procédé permettant de réaliser un tel combineur RF à ondes acoustiques de volume.

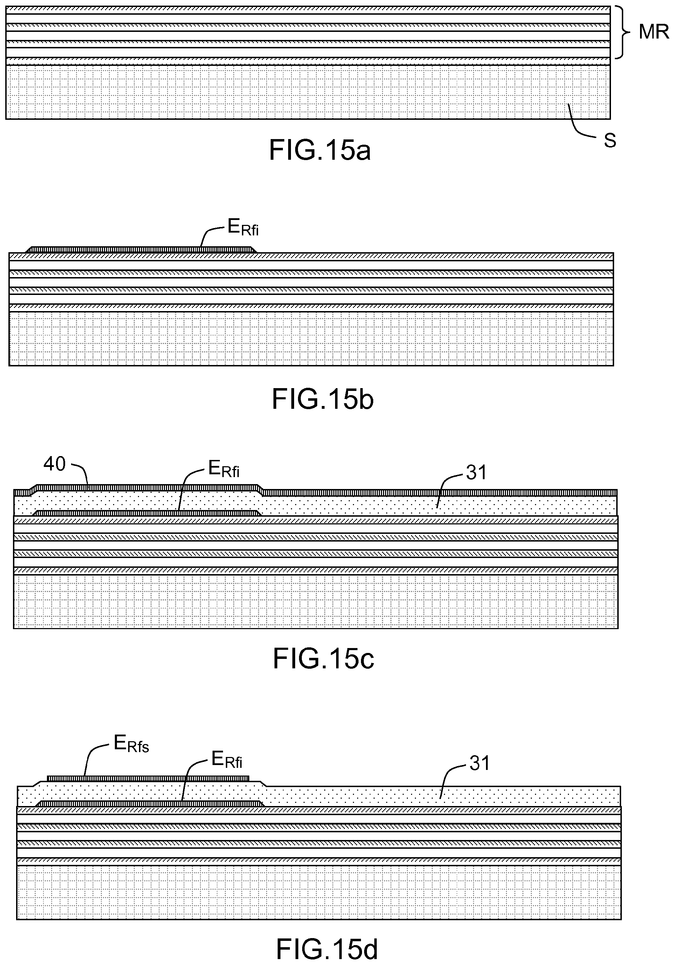

Selon une première étape illustrée en figure 15a, on procède au dépôt de couches de SiN et de SiOC composant le miroir de Bragg MR, sur un substrat silicium S, haute résistivité par CVD.

Selon une seconde étape illustrée en figure 15b, on procède au dépôt des électrodes $E_{Rfi}$ par pulvérisation de molybdène et définition par gravure sèche fluorée.

Selon une troisième étape illustrée en figure 15c, on procède au dépôt d'une première couche 31 de matériau piézoélectrique de AlN par pulvérisation réactive puisée, et d'une couche 40 par pulvérisation de Molybdène.

Selon une quatrième étape illustrée en figure 15d, on procède à la définition des électrodes, par gravure sèche fluorée, de manière à définir le résonateur inférieur dit flottant, à ondes de volume entre deux électrodes $E_{Rfi}$ et $E_{Rfs}$.

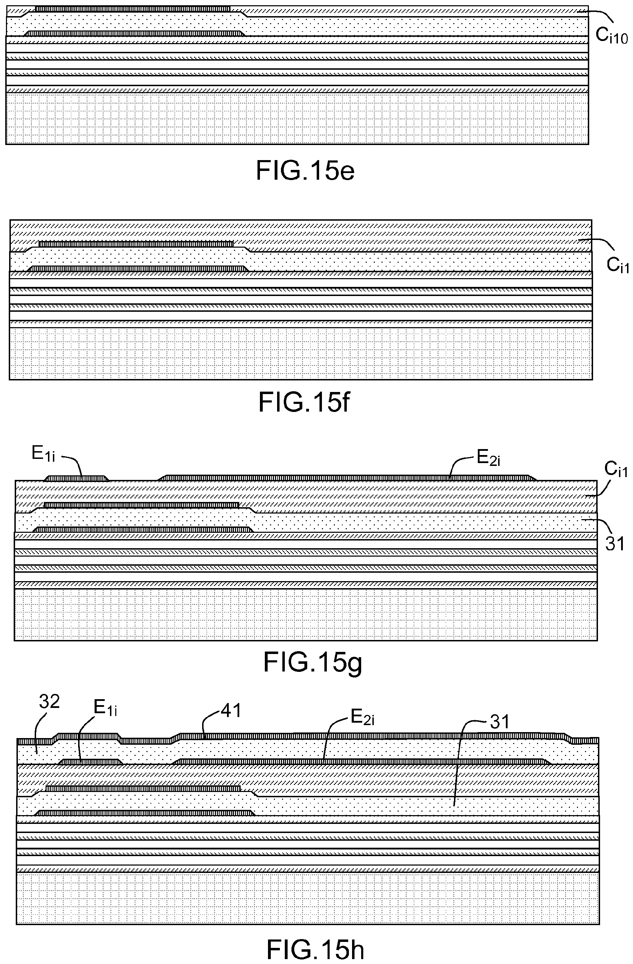

Selon une cinquième étape illustrée en figure 15e, on procède au dépôt d'une couche $Ci_{10}$ de $SiO_2$ par CVD, suivie d'une étape de planarisation.

Selon une sixième étape illustrée en figure 15f, on procède au dépôt du milieu de propagation correspondant à la première couche intermédiaire épaisse $C_{i1}$ en $SiO_2$ déposée par CVD.

Selon une septième étape illustrée en figure 15g, on procède au dépôt des électrodes en molybdène par pulvérisation et définition par gravure sèche fluorée, permettant de définir les électrodes inférieures $E_{1i}$ et $E_{2i}$ des deux résonateurs d'entrée ;

Selon une huitième étape illustrée en figure 15h, on procède aux dépôts d'une seconde couche 32 en matériau AlN par pulvérisation réactive puisée, et d'une couche 41 par pulvérisation de molybdène.

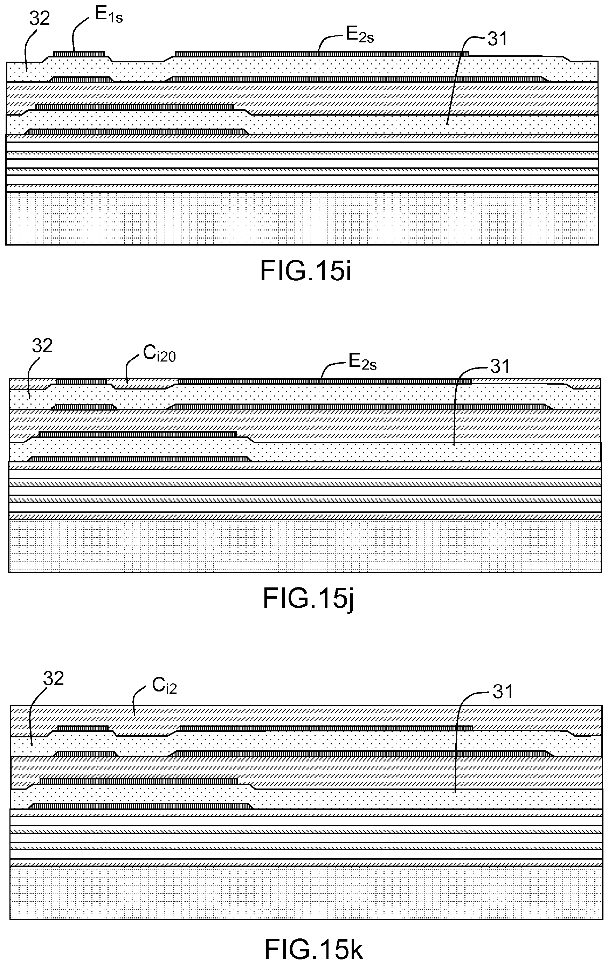

Selon une neuvième étape illustrée en figure 15i, on procède à la définition des électrodes $E_{1s}$ et $E_{2s}$ par gravure sèche fluorée.

Selon une dixième étape illustrée en figure 15j, on procède au dépôt d'une couche $C_{i20}$ de $SiO_2$ par CVD et planarisation.

Selon une dixième étape illustrée en figure 15k, on procède au dépôt du milieu de propagation correspondant à la seconde couche intermédiaire $C_{i2}$ réalisée en $SiO_2$ et déposée par CVD.

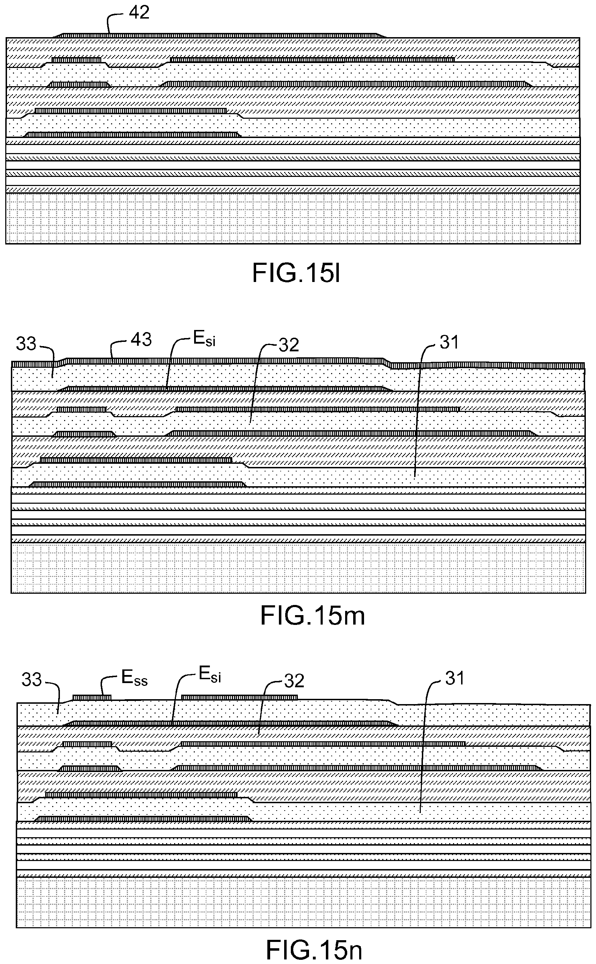

Selon une onzième étape illustrée en figure 15l, on procède au dépôt d'une couche de molybdène 42 par pulvérisation et définition par gravure sèche fluorée.

Selon une douzième étape illustrée en figure 15m, on procède au dépôt d'une troisième couche 33 de matériau piézoélectrique en AlN par pulvérisation réactive puisée, et des électrodes par pulvérisation de molybdène, définissant ainsi le résonateur de sortie au dessus d'une électrode inférieure $E_{si}$.

Selon une treizième étape illustrée en figure 15n, on procède à la définition des électrodes $E_{ss}$ par gravure sèche fluorée.

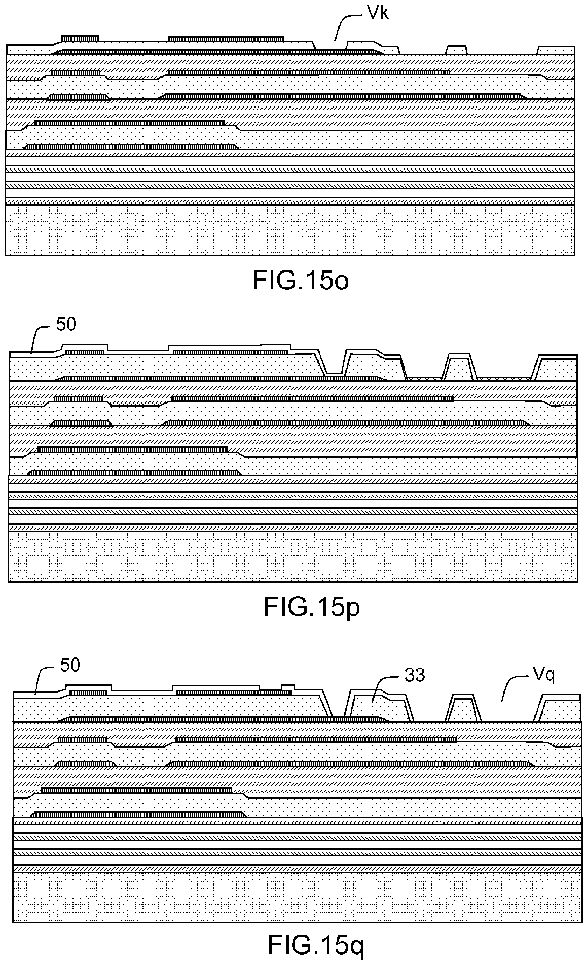

Selon une quatorzième étape illustrée en figure 15o, on procède à l'ouverture de vias Vk dans l'AlN par gravure humide $H_3PO_4$.

Selon une quinzième étape illustrée en figure 15p, on procède au dépôt d'une couche de passivation 50 en SiN par PVD.

Selon une seizième étape illustrée en figure 15q, on procède à l'ouverture de vias Vq dans la couche de passivation par gravure sèche fluorée.

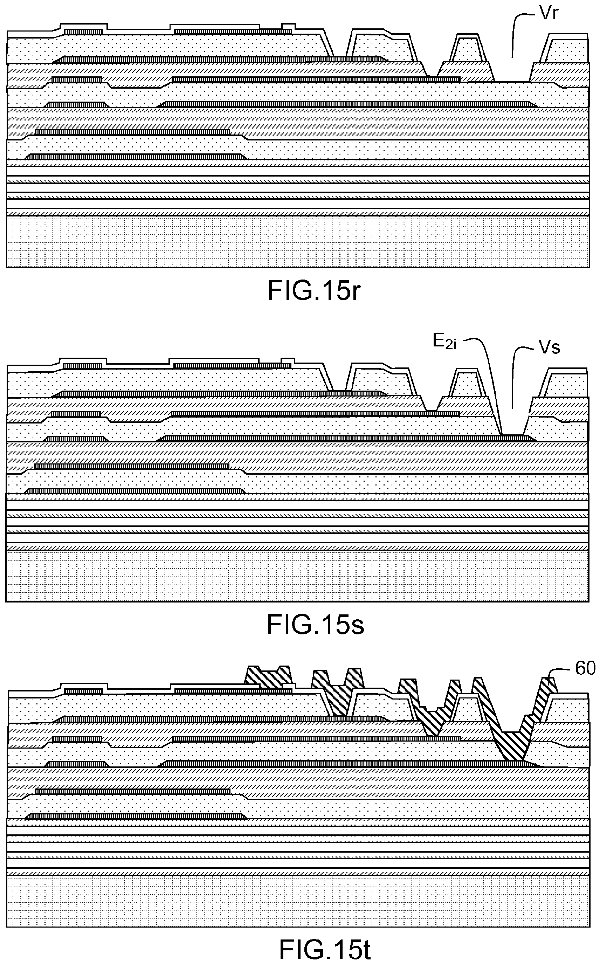

Selon une dix-septième étape illustrée en figure 15r, on procède à l'ouverture de vias Vr dans la couche de propagation par gravure sèche fluorée.

Selon une dix-huitième étape illustrée en figure 15s, on procède à la gravure humide $H_3PO_4$ de l'AlN conduisant à des ouvertures Vs permettant d'accéder à l'électrode $E_{2i}$.

Selon une dix-neuvième étape illustrée en figure 15t, on procède à la réalisation de contacts en AlCu par pulvérisation d'une couche 60 et définition par humide $H_3PO_4$.

**Revendications**

1. Combineur de signaux électriques comprenant au moins un premier élément et un second élément connectés respectivement à un premier port d'entrée ($P_1$) et à un second port d'entrée ($P_2$), et un troisième élément connecté à un port de sortie (Ps), les signaux électriques étant propagés entre les ports d'entrée et de sortie, à l'aide des ondes acoustiques de volume où :

    - lesdits premier, second et troisième éléments sont des transducteurs à ondes acoustiques de volume propagées à une longueur d'onde acoustique $\lambda$ ;
    - ledit combineur comporte un support de propagation dans lequel sont empilés les transducteurs d'entrée et de sortie, le support de propagation comportant au moins une couche de matériau piézoélectrique apte à permettre la propagation d'ondes acoustiques de volume, chaque transducteur comprenant un empilement d'au moins une couche de matériau piézoélectrique et d'au moins deux électrodes respectivement disposées d'une part et d'autre de la couche de matériau piézoélectrique ;

**caractérisé en ce que** :

- ledit combineur comporte une structure de repliement du chemin du signal qui se propage dans la structure à la fois sous forme électrique et sous forme acoustique, la structure de repliement comportant trois niveaux de résonateurs à ondes de volume, empilés dans l'ordre suivant :

⚬ un premier niveau comprenant un transducteur à ondes acoustiques de volume inférieur;
⚬ un second niveau comprenant, en tant que premier élément, un premier transducteur intermédiaire à ondes acoustiques de volume connecté au premier port d'entrée ($P_1$) et, en tant que second élément, un second transducteur intermédiaire à ondes acoustiques de volume connecté au second port ($P_2$), lesdits transducteurs intermédiaires étant séparés du transducteur inférieur par une première couche intermédiaire;
⚬ un troisième niveau comprenant, en tant que troisième élément, un transducteur supérieur à ondes acoustiques de volume connecté au port de sortie (Ps), séparé des transducteurs intermédiaires par une seconde couche intermédiaire;
⚬ l'épaisseur totale du transducteur supérieur et de la seconde couche intermédiaire présentant une épaisseur totale de $(2k+1)\lambda/4$ avec k entier supérieur ou égal à 0;
⚬ l'épaisseur totale des transducteurs intermédiaires et de la première couche intermédiaire présentant une épaisseur totale de $(2k'+2)\lambda/4$ avec k' entier supérieur ou égal à 0;

de manière à d'une part générer des interférences constructives au niveau du port de sortie et d'autre part isoler lesdits premiers et seconds ports d'entrée par interférence d'ondes acoustiques destructives au niveau desdits ports d'entrée.

2. Combineur selon la revendication 1, **caractérisé en ce que** les transducteurs comprennent une couche piézoélectrique en AIN, les couches intermédiaires étant en $SiO_2$.

3. Combineur selon l'une des revendications précédentes, le combineur étant un combineur RF.

4. Combineur selon l'une des revendications précédentes, **caractérisé en ce que** les transducteurs comportent un matériau piézoélectrique à coefficient de couplage piézoélectrique, supérieur à 0,5% et de préférence supérieur à 10%.

**Patentansprüche**

1. Kombinator für elektrische Signale, der wenigstens ein erstes Element und ein zweites Element, die jeweils mit einem ersten Eingangsport ($P_1$) und einem zweiten Eingangsport ($P_2$) verbunden sind, und ein drittes Element umfasst, das mit einem Ausgangsport (Ps) verbunden ist, wobei sich die elektrischen Signale zwischen den Ein- und Ausgangsports ausbreiten, mit Hilfe von akustischen Volumenwellen, wobei:

- das erste, zweite und dritte Element akustische Volumenwellenwandler sind, die sich mit einer akustischen Wellenlänge λ ausbreiten;
- der Kombinator ein Ausbreitungsmedium umfasst, in dem die Ein- und Ausgangswandler gestapelt sind, wobei das Ausbreitungsmedium wenigstens eine piezoelektrische Materialschicht umfasst, die die Ausbreitung von akustischen Volumenwellen zulässt, wobei jeder Wandler einen Stapel von wenigstens einer piezoelektrischen Materialschicht und von wenigstens zwei Elektroden umfasst, die jeweils auf beiden Seiten der piezoelektrischen Materialschicht angeordnet sind;

**dadurch gekennzeichnet, dass**:

- der Kombinator eine Struktur zum Falten des Wegs des Signals umfasst, das sich in der Struktur gleichzeitig in elektrischer Form und in akustischer Form ausbreitet, wobei die Faltungsstruktur drei Volumenwellenresonatorniveaus umfasst, die in der folgenden Reihenfolge gestapelt sind:

⚬ ein erstes Niveau, das einen akustischen Wellenwandler mit niedrigem Volumen umfasst;
⚬ ein zweites Niveau, das als erstes Element einen ersten akustischen Volumenwellen-Zwischenwandler umfasst, der mit dem ersten Eingangsport ($P_1$) verbunden ist, und als zweites Element einen akustischen Volumenwellen-Zwischenwandler umfasst, der mit dem zweiten Port (P$_2$) verbunden ist, wobei die Zwischenwandler vom unteren Wandler durch eine erste Zwischenschicht getrennt sind;

◦ ein drittes Niveau, das als drittes Element einen oberen akustischen Volumenwellenwandler umfasst, der mit dem Ausgangsport (Ps) verbunden ist, der von den Zwischenwandlern durch eine zweite Zwischenschicht getrennt ist;

◦ wobei die Gesamtdicke des oberen Wandlers und der zweiten Zwischenschicht eine Gesamtdicke von (2k+1)$\lambda$/4 aufweist, wobei k eine ganze Zahl gleich oder größer als 0 ist;

◦ wobei die Gesamtdicke der Zwischenwandler und der ersten Zwischenschicht eine Gesamtdicke von (2k'+2)$\lambda$/4 aufweist, wobei k' eine ganze Zahl gleich oder größer als 0 ist;

um einerseits konstruktive Interferenzen am Ausgangsport zu erzeugen und andererseits den ersten und zweiten Eingangsport durch Interferenz von destruktiven akustischen Wellen an den Eingangsports zu isolieren.

2. Kombinator nach Anspruch 1, **dadurch gekennzeichnet, dass** die Wandler eine piezoelektrische Schicht aus AlN umfassen, wobei die Zwischenschichten aus SiO$_2$ sind.

3. Kombinator nach einem der vorherigen Ansprüche, wobei der Kombinator ein RF-Kombinator ist.

4. Kombinator nach einem der vorherigen Ansprüche, **dadurch gekennzeichnet, dass** die Wandler ein piezoelektrisches Material mit einem piezoelektrischen Kopplungskoeffizienten größer als 0,5 % und vorzugsweise größer als 10 % umfassen.

**Claims**

1. Combiner for electrical signals comprising at least one first element and a second element respectively connected to a first input port (P$_1$) and to a second input port (P$_2$), and a third element connected to an output port (Ps), the electrical signals being propagated between the input and output ports by bulk acoustic waves, wherein:

- said first, second and third elements are bulk acoustic wave transducers, the waves being propagated at an acoustic wavelength $\lambda$;
- said combiner comprising a propagation medium in which the input and output transducers are stacked, the propagation medium comprising at least one layer of piezoelectric material capable of allowing the propagation of bulk acoustic waves, each transducer comprising a stack of at least one layer of piezoelectric material and at least two electrodes located on either side of the layer of piezoelectric material, respectively;

**characterized in that**:

- said combiner comprises a structure for folding back the path of the signal propagating in the structure in an electrical and in an acoustic form simultaneously, the structure for folding back comprising three levels of bulk wave resonators that are stacked in the following order:

◦ a first level comprising a lower bulk acoustic wave transducer;
◦ a second level comprising, as a first element, a first intermediate bulk acoustic wave transducer connected to the first input port (P$_1$) and, as a second element, a second intermediate bulk acoustic wave transducer connected to the second port (P$_2$), said intermediate transducers being separated from the lower transducer by a first intermediate layer;
◦ a third level comprising, as a third element, an upper bulk acoustic wave transducer connected to the output port (Ps), separated from the intermediate transducers by a second intermediate layer;
◦ the total thicknesses of the upper transducer and of the second intermediate layer having a total thickness of (2k+1)$\lambda$/4 with k an integer greater than or equal to 0;
◦ the total thicknesses of the intermediate transducers and of the first intermediate layer having a total thickness of (2k'+2)$\lambda$/4 with k' an integer greater than or equal to 0;
so as to, on the one hand, generate constructive interferences at the output port and, on the other hand, to isolate said first and second input ports by interference of destructive acoustic waves at said input ports.

2. The combiner according to claim 1, **characterized in that** the transducers comprise a piezoelectric layer composed of A1N, the intermediate layers being composed of SiO$_2$.

3. The combiner according to one of the preceding claims, the combiner being an RF combiner.

4. The combiner according to one of the preceding claims, **characterized in that** the transducers comprise a piezoelectric material with a piezoelectric coupling coefficient greater than 0.5% and preferably greater than 10%.

Port 1

Port 2

Entrées

Port N

Isolation

Sortie

Σ (Port 1, Port 2… Port N)

## FIG.1

$P_{1e}$

$T_S$

$P_{2e}$

M

$T_1$

$P_S$

$T_2$

## FIG.2

$P_1$

$P_2$

M

$\lambda$

$\lambda/4$

$T_S$

$\lambda/4$

$\lambda$

$T_1$

$P_S$

$T_2$

## FIG.3

FIG.4

FIG.5

FIG.6

FIG.7

FIG.8

FIG.9a

FIG.9b

Vi

1

S

## FIG.10a

2
1

S

## FIG.10b

$E_{1i}$  $E_{si}$  $E_{2i}$

## FIG.10c

4  3
2
1

S

## FIG.10d

$E_{1i}$  $E_{si}$  $E_{2i}$

FIG.10e

Vj

FIG.10f

3  5  2  1  S

FIG.10g

6  5  3

FIG.10h

**FIG.10i**

**FIG.10j**

**FIG.10k**

FIG.11a

FIG.11b

FIG.12a

FIG.12b

FIG.12c

FIG.12d

FIG.12e

FIG.12f

FIG.12g

FIG.12h

FIG.12i

FIG.13a

FIG.13b

FIG.13c

FIG.14a

FIG.14b

MR

S

FIG.15a

$E_{Rfi}$

FIG.15b

40          $E_{Rfi}$          31

FIG.15c

$E_{Rfs}$     $E_{Rfi}$          31

FIG.15d

$C_{i10}$

FIG.15e

$C_{i1}$

FIG.15f

$E_{1i}$    $E_{2i}$    $C_{i1}$

31

FIG.15g

32    $E_{1i}$    41    $E_{2i}$    31

FIG.15h

FIG.15i

FIG.15j

FIG.15k

FIG.15l

FIG.15m

FIG.15n

**FIG.15o**

**FIG.15p**

**FIG.15q**

FIG.15r

FIG.15s

FIG.15t

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 60160719 B
- FR 2926421
- GB 1473661 A

**Littérature non-brevet citée dans la description**

- **A.REINHARDT ; V.LAUDE ; M.SOLAL ; S.BALLANDRAS ; W.STEICHE.** Investigation of spurious résonances in Thin Film Bulk Acoustic Wave Resonators. *Proceedings of the 2004 IEEE Ultrasonics Symposium et S.Ballandras*
- **V.LAUDE.** Simulation of transverse effects in FBAR devices. *IEEE MTT6S Digest,* 2005